# EUROPÄISCHE PATENTANMELDUNG

(11) **EP 2 676 761 A2**
(43) Veröffentlichungstag der Anmeldung: **25.12.2013**
(21) Anmeldenummer: 13001732.0
(22) Anmeldetag: 04.04.2013
(51) Int. Cl.: B23K 11/24, B23K 11/25

(54) **Verfahren zur Überwachung der Restlebensdauer von während des Betriebs einer Widerstandsschweißeinrichtung mit Strom beaufschlagten Leistungshalbleitern der Widerstandsschweißvorrichtung**

(30) Priorität: 19.06.2012 DE 102012012056; 26.02.2013 DE 102013003183
(71) Anmelder: ROBERT BOSCH GMBH, 70442 Stuttgart (DE)
(72) Erfinder: Scholz, Reinhard, 64711 Erbach (DE)
(74) Vertreter: Thürer, Andreas

(57) **Zusammenfassung**

Die Lebensdauer der Leistungshalbleiter einer Widerstandsschweißvorrichtung bestimmt wesentlich die Zuverlässigkeit der Anlage im Betrieb. Die Erfindung schlägt ein Verfahren zur Überwachung der Restlebensdauer von während des Betriebs einer Widerstandsschweißvorrichtung mit Strom beaufschlagten Leistungshalbleitern vor. Dadurch, dass bei einem Lastwechsel zumindest eines Leistungshalbleiters die Veränderung eines Leistungshalbleiterparameters ermittelt wird und die Leistungshalbleiterlebensdauer unter Berücksichtigung einer für die Restlebensdauer repräsentativen Sollvorgabe ermittelt wird, kann die Zuverlässigkeit der Anlage drastisch verbessert werden.

## Beschreibung

Die Erfindung betrifft ein Verfahren zur Überwachung der Restlebensdauer von während des Betriebs einer Widerstandsschweißvorrichtung mit Strom beaufschlagten Leistungshalbleitern der Widerstandsschweißvorrichtung,

Zahlreiche mechanisch oder thermisch stark beanspruchte Bauteile von Maschinen, elektrischen Anlagen oder Kraftfahrzeugen weisen ein mit zunehmender Temperatur schneller fortschreitendes Materialalterungs- bzw. Verschleißverhalten auf. Als Beispiele seien hier Leistungshalbleiter genannt.

Werden derartige Bauteile über den Normalbetrieb hinaus in besonderer Weise thermisch beansprucht, so kann es zu unerwarteten Betriebsbeeinträchtigungen oder gar zu Betriebsausfällen kommen. Dem kann einerseits dadurch begegnet werden, daß man die Bauteile in hinreichend kurzen Sicherheitszeitintervallen wartet oder, wo das nicht möglich ist, rechtzeitig austauscht. Die Wartung ist allerdings in aller Regel mit einem aufwändigen Eingriff in das betreffende Bauteil verbunden, wobei sich oft erst dann herausstellt, daß das Bauteil noch uneingeschränkt betriebsfähig und somit noch nicht wartungsbedürftig ist. Bei einem routinemäßigen Austausch von Bauteilen aus Sicherheitsgründen, wie beispielsweise von elektrischen Bauteilen, deren Alterungszustand ohne Zerstörung des Bauteils nicht feststellbar ist, kommt es häufig zur Aussonderung von durchaus noch über längere Zeit betriebsfähigen Bauteilen.

Es besteht daher Bedarf nach einer Möglichkeit, das Alterungs- bzw. Verschleißverhalten von Bauteilen oder sonstigen temperaturabhängig alternden Gegenständen mit einfachen Mitteln zu überwachen.

Bei den heutigen Systemen werden nur Belastungsgrenzen der Leistungshalbleiter überwacht. Sind diese Grenzen erreicht und schlägt die Überwachung an, so ist es meist schon zu spät.

Ziel der Erfindung ist es, eine vorbeugende Wartung vorzusehen, welche die zu erwartende Lebensdauer unter Berücksichtigung des bisher stattgefundenen Verschleißes prognostiziert.

Hierfür stellt die Erfindung ein Verfahren gemäß den Patentansprüchen zur Verfügung.

Das Verfahren ermöglichst es, dass die Restlebensdauer der Leistungshalbleiters einer Widerstandsschweißvorrichtung abhängig vom Verschleiß der Leistungshalbleiter an einen Anwender kommuniziert wird, so dass dieser frühzeitig die erforderlichen Maßnahmen ergreifen kann.

Die aus dem Stand der Technik bekannten Nachteile sind damit behoben.

Weitere vorteilhafte Ausgestaltungen der Erfindung ergeben sich aus den abhängigen Patentansprüchen.

Das erfindungsgemäße Verfahren kann für alle Leistungshalbleiter verwendet werden, beispielsweise die Schweißdioden im Schweißtrafo oder die Leistungshalbleiter im Schweißumrichter oder Schweißgleichrichter.

Nach jedem Schweißpunkt wird mittels des während des Schweißens auftretenden Schweißstromes, eines Skalenteilwertes, diversen für den Leistungshalbleiter charakteristischen Konstanten und dem thermischen Widerstand entsprechend der Schweißzeit die Temperaturerhöhung des Leistungshalbleiters ermittelt. Unter Abhängigkeit der Schweißzyklen in Abhängigkeit der Temperaturerhöhung des Leistungshalbleiters kann der für die Lebensdauer des Leistungshalbleiters relevante Anteil jedes Schweißpunktes aufsummiert und unter Verwendung der Herstellerangaben die Restlebensdauer automatisch von der Schweißsteuerung ermittelt werden.

## Patentansprüche

1. Verfahren zur Überwachung der Restlebensdauer von während des Betriebs einer Widerstandsschweißvorrichtung mit Strom beaufschlagten Leistungshalbleitern der Widerstandsschweißvorrichtung, wobei bei einem Lastwechsel zumindest eines Leistungshalbleiters die Veränderung eines Leistungshalbleiterparameters ermittelt wird und die Leistungshalbleiterlebensdauer unter Berücksichtigung einer für die Restlebensdauer repräsentativen Sollvorgabe ermittelt wird.

2. Verfahren gemäß Anspruch 1, wobei der Lastwechsel bei der Durchführung eines Schweißvorgangs entsteht, wobei unter Berücksichtigung der Dauer des Schweißvorgangs die Veränderung des Leistungshalbleiterparameters ermittelt wird und wobei es sich bei dem Leistungshalbleiterparameter vorzugsweise um die Leistungshalbleitertemperatur handelt.

3. Verfahren gemäß Anspruch 1 oder 2, wobei jede ermittelte Veränderung des Leistungshalbleiterparameters unter Berücksichtigung des zugehörigen Lastwechsels abgespeichert wird, so dass die Anzahl der Lastwechsel in Relation zu der Veränderung des Leistungshalbleiterparameters als Wertepaar abrufbar ist.

4. Verfahren gemäß einem der vorhergehenden Ansprüche, wobei es sich bei den Leistungshalbleitern um vom Schweißumrichter umfassten Leistungshalbleitern und/oder um vom Schweißtransformator umfassten Leistungshalbleitern und/oder um vom Schweißgleichrichter umfassten Leistungshalbleitern handelt.

5. Verfahren gemäß einem der vorhergehenden Ansprüche, wobei die Restlebensdauer von einer von der Widerstandsschweißvorrichtung umfassten Schweißsteuerung ermittelt wird.

6. Verfahren gemäß Anspruch 5, wobei die Restlebensdauer mittels einer von der Widerstandsschweißvorrichtung umfassten Bedieneinrichtung abrufbar ist.
